# EUROPEAN PATENT APPLICATION

(11) **EP 4 796 231 A1**
(43) Date of publication of application: **26.08.2026**
(21) Application number: 24878654.3
(22) Date of filing: 15.08.2024
(51) Int. Cl.: B05C 5/02, B05C 13/00, B05C 11/00, B05D 3/06

(54) **SOLAR CELL DISPENSING APPARATUS AND SOLAR CELL MANUFACTURING DEVICE**

(30) Priority: 17.10.2023 CN 202322779198 U
(71) Applicant: Suzhou Maizhan Automation Technology Co., Ltd., Suzhou, Jiangsu 215000 (CN)
(72) Inventor: TAO, Yi, Suzhou, Jiangsu 215000 (CN); GANG, Yunlong, Suzhou, Jiangsu 215000 (CN)
(74) Representative: Balder IP Law, S.L.
(86) International application number: PCT/CN2024/112242
(87) International publication number: WO 2025/082002

(57) **Abstract**

The present application discloses a solar cell dispensing apparatus and solar cell manufacturing device, belongs to the solar cell field. A solar cell dispensing apparatus for use in a solar cell manufacturing device, and comprises a dispensing control unit, a dispensing execution unit, a CCD positioning camera, and a UV curing lamp; the CCD positioning camera, the dispensing execution unit, and the UV curing lamp are all arranged above a cell conveyor belt, and are sequentially arranged along a conveying direction of a solar cell; the CCD positioning camera and the dispensing execution unit are both connected to the dispensing control unit, and the dispensing control unit is configured to receive images acquired by the CCD positioning camera and to control the dispensing execution unit to execute a dispensing operation. The present application can solve the problems in the known art that the yield of solar cells is low and the manufacturing costs are high due to the dispensing precision not meeting the standard.

## Description

### TECHNICAL FIELD

The present application relates to the technical field of solar energy, and refers to annealing or curing heat treatment, and in particular, refers to a solar cell dispensing apparatus and solar cell manufacturing device.

### BACKGROUND

For solar cells, the metallization cost accounts for a relatively large proportion. Traditional cell requires to print main and secondary silver grid lines on both sides of the cell, and print thick pad points at specific positions on each main grid line to increase the bonding force when the cell is soldered to a solder ribbon. Therefore, this traditional cell makes it difficult to reduce the metallization cost of the cell.

With the continuous development of the solar cell and the assembly process, new processes continue to emerge. For example, a solar cell without main grids and pad points forms an alloy between the secondary grid line and the solder ribbon during soldering. Since the contact area between the secondary grid line and the solder ribbon is small, the bonding force of this alloy is not as good as the bonding force of the alloy formed between the main grid plus pad point of the traditional solar cell and the solder ribbon. Therefore, it is necessary to strengthen the bonding force between the solder ribbon and the solar cell after soldering. Chinese patent CN115224162A-a photovoltaic cell string manufacturing apparatus also provides a process solution of first welding and then dispensing to strengthen the bonding force between the solder ribbon and the solar cell. However, since the original dispensing process is generally used in the 3C industry, which varies significantly from the field of solar cells, and the requirements for dispensing also vary significantly. Therefore, the original dispensing apparatus and device are less suitable for strengthening the bonding force between the secondary grid of the solar cell and the solder ribbon.

### SUMMARY

The present application aims to solve at least one of the technical problems in the above-mentioned related technologies to a certain extent.

To this end, an object of the present application is to provide a solar cell dispensing apparatus and solar cell manufacturing device, which can solve the problems in the known art that the yield of solar cells is low and the manufacturing costs are high due to the dispensing precision not meeting the standard.

In order to solve the above technical problems, the present application is implemented as follows:
The embodiment of the present application provides a solar cell dispensing apparatus for use in a solar cell manufacturing device, and the dispensing apparatus comprises: a dispensing control unit, a dispensing execution unit, a CCD positioning camera and a UV curing lamp;
the CCD positioning camera, the dispensing execution unit and the UV curing lamp are all arranged above a cell conveyor belt, and are sequentially arranged along a conveying direction of a solar cell;
the CCD positioning camera and the dispensing execution unit are both connected to the dispensing control unit, and the dispensing control unit is configured to receive images acquired by the CCD positioning camera and to control the dispensing execution unit to execute a dispensing operation.

In addition, the solar cell dispensing apparatus according to the present application may further have the following additional technical features:
In some of the embodiments, the dispensing execution unit comprises a fixing mechanism, a driving mechanism, two sliding rails, a sliding mechanism, a glue valve connecting bracket, a glue valve group and a glue cylinder group;.
the fixing mechanism is fixedly arranged above the cell conveyor belt, the driving mechanism is arranged on the fixing mechanism; the sliding rails are respectively arranged at the upper and lower ends of the fixing mechanism, and are both arranged horizontally;
the sliding mechanism is slidably connected to the two sliding rails at the same time, and is connected to the driving mechanism, and slides along the sliding rails under the driving action of the driving mechanism;
the glue valve connecting bracket is connected to the sliding mechanism, and the glue valve group and the glue cylinder group are both arranged on the glue valve connecting bracket.

In some of the embodiments, the driving mechanism and the glue valve group are both connected to the dispensing control unit.

In some of the embodiments, the glue valve group comprises a plurality of rows of single glue valves, each row comprises a plurality of single glue valves; the glue outlets of the single glue valves in each row are on a same straight line.

In some of the embodiments, the straight line where the glue outlets of the single glue valves in each row are located is perpendicular to the secondary grid line on the cell.

In some of the embodiments, the sliding rails are parallel to the length direction of the cell conveyor belt; the secondary grid line of the cell to be dispensed is perpendicular to the length direction of the cell conveyor belt.

In some of the embodiments, the sliding mechanism comprises a L-shaped connecting piece, a horizontal section of the L-shaped connecting piece is threadedly connected to the glue valve connecting bracket, so that the glue valve connecting bracket is arranged horizontally.

In some of the embodiments, the glue valve connecting bracket is provided with a plurality of glue valve mounting positions and a plurality of glue cylinder mounting positions, the glue valve mounting positions are centrally arranged in the middle, and the glue cylinder mounting positions are arranged around and above the area where the glue valve mounting positions are located.

In some of the embodiments, the driving mechanism is a lead screw motor or an electric cylinder.

The embodiment of the present application further provides a solar cell manufacturing device, which comprises the solar cell dispensing apparatus as described above.

Compared with the known art, the present disclosure has at least the following beneficial effects:

In the embodiment of the present application, the solar cell dispensing apparatus provided can realize efficient and high-quality dispensing operations on the busbarless solar cell after welding, so that the secondary grid line and the solder ribbon have better bonding force, which facilitates the conveying and pressing of subsequent processes, reduces the cost of solar cell metallization and contributes to the promotion and application of busbarless solar cell technology.

The solar cell manufacturing device of the present application comprises the solar cell dispensing apparatus, and therefore has at least all the features and advantages of the solar cell dispensing apparatus, which will not be repeated here. Additional aspects and advantages of the present application will be partially given in the following description, and partially will become apparent from the following description, or may be learned from the practice of the present application.

### BRIEF DESCRIPTION OF THE DRAWINGS

FIG. 1 is a schematic structural diagram of a solar cell dispensing apparatus disclosed in an embodiment of the present application;
FIG. 2 is a schematic structural diagram of a dispensing execution unit of a solar cell dispensing apparatus disclosed in an embodiment of the present application;
FIG. 3 is a schematic structural diagram of a cell string before and after dispensing disclosed in an embodiment of the present application; wherein, (a) is before glue dispensing, (b) is after glue dispensing.

Description of elements in the drawings:
1-dispensing control unit; 2-dispensing execution unit; 3-CCD positioning camera; 4-UV curing lamp; 5-cell;
201-execution unit fixed driving mechanism; 202-sliding rail; 203-sliding mechanism; 204-glue valve connecting bracket; 205-glue valve group; 206-glue cylinder group.

### DETAILED DESCRIPTION OF THE EMBODIMENTS

The technical solutions in the embodiments of the present application will be clearly and completely described below with reference to the accompanying drawings in the embodiments of the present application. Apparently, the described embodiments are some rather than all of the embodiments of the present application. All other embodiments obtained by a person of ordinary skill in the art based on the embodiments of the present application without creative efforts shall fall within the protection scope of the present application.

The following describes the embodiments of the present application in detail through specific embodiments and application scenarios thereof with reference to the accompanying drawings.

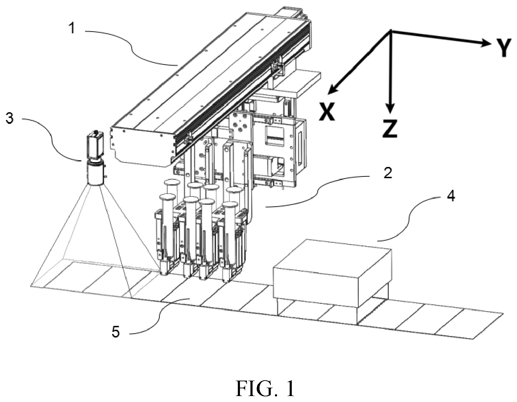

Please refer to FIG. 1, in some embodiments of the present application, a solar cell dispensing apparatus is provided, which can be applied to a solar cell manufacturing device. For example, in the manufacturing process of a solar cell, secondary grid lines and solder ribbon form an alloy. Since the contact area between the secondary grid line and the solder ribbon is small, the bonding force of the alloy is insufficient, and the bonding force between the solder ribbon and the cell needs to be strengthened by using dispensing. The dispensing apparatus can be used to realize the dispensing operation on the cell, and can be used to solve the problems in the known art that the yield of solar cells is low and the manufacturing costs are high due to the dispensing precision not meeting the standard. In addition, the glue dispensing apparatus may also be used in other devices or perform other types of dispensing processing, and the specific use scenarios and working conditions of the glue supplying apparatus are not specifically limited in the embodiments of the present application.

Specifically, the solar cell dispensing apparatus comprises: a dispensing control unit 1, a dispensing execution unit 2, a CCD positioning camera 3 and a UV curing lamp 4.

Wherein the dispensing execution unit 2 and the CCD positioning camera 3 are both connected to the dispensing control unit 1. The CCD positioning camera is arranged above a string of cells 5 transported with a conveyor belt, and uses pictures to collect the position coordinate information of the solder ribbon on the cell, and transmits the position coordinate information to the dispensing control unit 1. According to the acquired pictures, the dispensing control unit 1 is configured to analyze to obtain specific position coordinates of each solder ribbon on each cell. According to the analyzed solder ribbon position coordinates, the dispensing control unit 1 is configured to control the dispensing execution unit 2 to move and to execute a dispensing operation at the corresponding position. The CCD positioning camera 3 is arranged in front of the dispensing execution unit 2. The front and rear of the present application refer to the front and rear for the conveying direction of the cell 5. After dispensing, the cell continues to be transported with the conveyor belt to the UV curing lamp 4 arranged at the rear of the glue dispensing execution unit 2 for UV curing. The glue spot is cured under the irradiation of UV, so that the solder ribbon and the cell are bonded together, thereby obtaining a better bonding force.

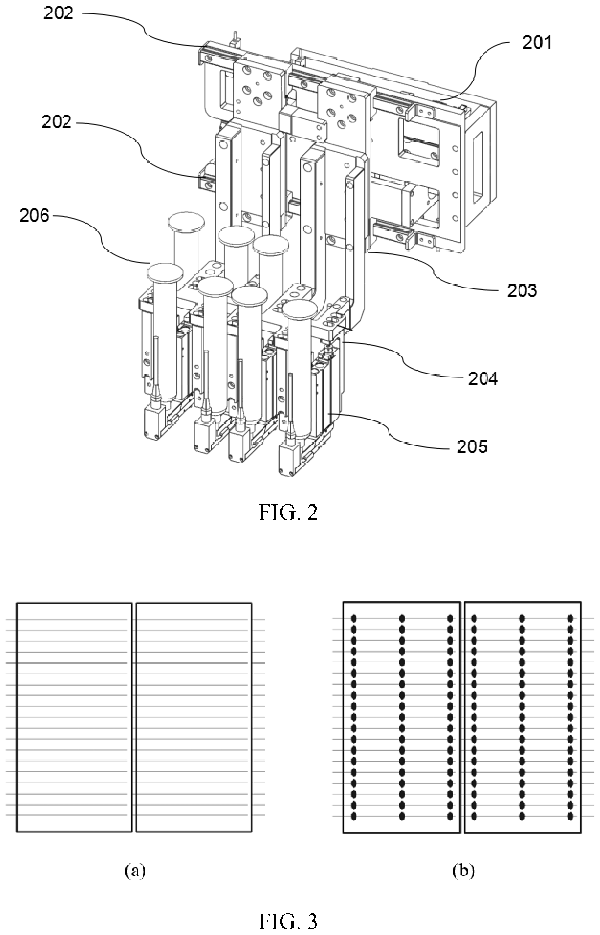

In some embodiments of the present application, referring to FIG. 2, the dispensing execution unit 2 comprises an execution unit fixed driving mechanism 201, a sliding rail 202, a sliding mechanism 203, a glue valve connecting bracket 204, a glue valve group 205 and a glue cylinder group 206. The execution unit fixed driving mechanism 201 is fixedly arranged above the conveyor belt. The execution unit fixed driving mechanism 201 comprises a fixing mechanism and a driving mechanism, the fixing mechanism is fixedly arranged above the conveyor belt, the driving mechanism is arranged in the fixing mechanism (not shown in the figure). The upper and lower ends of a side wall of the fixing mechanism are respectively provided with a horizontal sliding rail 202. The sliding mechanism 203 is slidably connected to the two sliding rails 202 at the same time, and is connected to the driving mechanism at the same time, and slides along the sliding rails 202 under the driving action of the driving mechanism. The driving mechanism is connected to the dispensing control unit 1 and performs operations under the instruction of the dispensing control unit 1. The glue valve connecting bracket 204 is detachably connected to the bottom of the sliding mechanism 203, and the glue valve group 205 and the glue cylinder group 206 are both fixed on the glue valve connecting bracket 204.

In some embodiments of the present application, the glue valve group 205 is composed of a plurality of single glue valves. The glue cylinder group 206 is composed of a plurality of glue supply cylinders. The number of the single glue valves and the glue supply cylinders is equal and is in one-to-one correspondence. In order to minimize the dispensing travel path, the glue valve group in the present application comprises a plurality of rows of single glue valves, each row comprises a plurality of single glue valves, and each row is arranged in a straight line, that is, the glue outlets of the single glue valves in each row are on a same straight line, and the straight line can be perpendicular to the secondary grid line on the cell. FIG. 2 shows a structural diagram of the arrangement of four rows of single glue valves and two single glue valves in each row. When dispensing, the glue valve group moves in a direction perpendicular to the length direction of the solder ribbon and performs dispensing at the corresponding position. FIG. 3 is a schematic diagram of comparison before and after dispensing. All single glue valves are connected to the dispensing control unit 1, and perform dispensing operation under the control of the dispensing control unit 1. The control content of the dispensing control unit 1 over the single glue valve comprises whether to dispense and the dispensing frequency. The sliding rail 202 is arranged parallel to the length direction of the conveyor belt, and the cell is placed in such a way that the secondary grid line is perpendicular to the length direction of the conveyor belt. The arrangement of the glue valves in a straight line and the movement of dispensing perpendicular to the length of the solder ribbon can shorten the dispensing path, optimize the dispensing path and improve operational efficiency.

In some embodiments of the present application, the driving mechanism for driving the sliding mechanism 203 to slide is a high-precision lead screw motor or a high-precision electric cylinder. All motors and electric cylinders driving the sliding mechanism are connected to the dispensing control unit 1 and perform operations under the control of the dispensing control unit 1.

In some embodiments of the present application, the sliding mechanism 203 comprises a L-shaped connecting piece, a horizontal section of the L-shaped connecting piece is threadedly connected to the glue valve connecting bracket 204, so that the glue valve connecting bracket 204 is arranged horizontally. The glue valve connecting bracket 204 is provided with a plurality of glue valve mounting positions and a plurality of glue cylinder mounting positions, the glue valve mounting positions and the glue cylinder mounting positions are respectively arranged in a straight line. More specifically, since the spacing between the positions where the dispensing is needed on the cell is small, in order to ensure the accuracy of the dispensing position and that the glue cylinder is sufficiently large enough to hold enough glue, all the single glue valves are arranged in the middle, and the corresponding glue cylinders are arranged at the periphery and above the glue valve area. FIG. 2 shows the situation where the glue cylinders are arranged at the periphery.

Optionally, the glue valve may perform dispensing in a point-chasing manner, that is, perform dispensing in the movement process of the cell. This manner may reduce the number of glue valves and reduce the cost of the device. In this dispensing manner, when the dispensing frequency of the glue valve is synchronized with the conveying speed of the cell, the valve group does not need to move, and the dispensing position can be changed by relying on the conveying of the cell.

Optionally, in order to improve production efficiency, the field of view of the CCD positioning camera 3 is large enough to simultaneously locate the positions of the solder strips on a plurality of cells; the glue valve group 205 can also perform dispensing on a plurality of cells simultaneously, and the irradiation area of the UV curing lamp 4 can also cover a plurality of cells.

In some of embodiments of the present application, two ends of the sliding rail 202 are provided with L-shaped limiting pieces, a right-angled plate of the L-shaped limiting piece is threadedly connected to the fixing mechanism of the execution unit fixed driving mechanism 201, and the other right-angled plate is perpendicular to the sliding rail 202, which plays a blocking and limiting role to prevent the sliding mechanism 203 from sliding out of the sliding rail.

It should be noted that the technology of positioning by the dispensing control unit according to the images captured by the CCD positioning camera may refer to the known art, which is not limited in this embodiment and will not be described in detail here.

The parts of the present application that are not described in detail are well known to those skilled in the art.

The embodiments of the present application are described above in conjunction with the accompanying drawings, but the present application is not limited to the above-mentioned specific implementation methods. The above-mentioned specific implementation methods are merely illustrative and not restrictive. Under the guidance of the present application, ordinary technicians in this field can also make many forms without departing from the purpose of the present application and the scope of protection of the claims, all of which are within the protection of the present application.

## Claims

1. A solar cell dispensing apparatus for use in a solar cell manufacturing device, wherein the dispensing apparatus comprises: a dispensing control unit, a dispensing execution unit, a CCD positioning camera and a UV curing lamp;
wherein the CCD positioning camera, the dispensing execution unit and the UV curing lamp are all arranged above a cell conveyor belt, and are sequentially arranged along a conveying direction of a solar cell; and
wherein the CCD positioning camera and the dispensing execution unit are both connected to the dispensing control unit, and the dispensing control unit is configured to receive images acquired by the CCD positioning camera and to control the dispensing execution unit to execute a dispensing operation.

2. The solar cell dispensing apparatus according to claim 1, wherein the dispensing execution unit comprises a fixing mechanism, a driving mechanism, two sliding rails, a sliding mechanism, a glue valve connecting bracket, a glue valve group and a glue cylinder group;
the fixing mechanism is fixedly arranged above the cell conveyor belt, the driving mechanism is arranged on the fixing mechanism; the sliding rails are respectively arranged at the upper and lower ends of the fixing mechanism, and are both arranged horizontally;
the sliding mechanism is slidably connected to the two sliding rails at the same time, and is connected to the driving mechanism, and slides along the sliding rails under the driving action of the driving mechanism;
the glue valve connecting bracket is connected to the sliding mechanism, and the glue valve group and the glue cylinder group are both arranged on the glue valve connecting bracket.

3. The solar cell dispensing apparatus according to claim 2, wherein the driving mechanism and the glue valve group are both connected to the dispensing control unit.

4. The solar cell dispensing apparatus according to claim 2, wherein the glue valve group comprises a plurality of rows of single glue valves, each row comprises a plurality of single glue valves; the glue outlets of the single glue valves in each row are on a same straight line.

5. The solar cell dispensing apparatus according to claim 4, wherein the straight line where the glue outlets of the single glue valves in each row are located is perpendicular to the secondary grid line on the cell.

6. The solar cell dispensing apparatus according to claim 2, wherein the sliding rails are parallel to the length direction of the cell conveyor belt; the secondary grid line of the cell to be dispensed is perpendicular to the length direction of the cell conveyor belt.

7. The solar cell dispensing apparatus according to claim 2, wherein the sliding mechanism comprises a L-shaped connecting piece, a horizontal section of the L-shaped connecting piece is threadedly connected to the glue valve connecting bracket, so that the glue valve connecting bracket is arranged horizontally.

8. The solar cell dispensing apparatus according to any one of claims 2 to 7, wherein the glue valve connecting bracket is provided with a plurality of glue valve mounting positions and a plurality of glue cylinder mounting positions, the glue valve mounting positions are centrally arranged in the middle, and the glue cylinder mounting positions are arranged around and above the area where the glue valve mounting positions are located.

9. The solar cell dispensing apparatus according to claim 2, wherein the driving mechanism is a lead screw motor or an electric cylinder.

10. A solar cell manufacturing device, comprising the solar cell dispensing apparatus according to any one of claims 1 to 9.
